(19) **Europäisches Patentamt**

**European Patent Office**

**Office européen des brevets**

(11) **EP 1 019 913 B1**

(12) **EUROPÄISCHE PATENTSCHRIFT**

(45) Veröffentlichungstag und Bekanntmachung des Hinweises auf die Patenterteilung:
**17.07.2002 Patentblatt 2002/29**

(51) Int Cl.⁷: **G11C 11/15**

(21) Anmeldenummer: **98954237.8**

(86) Internationale Anmeldenummer:
**PCT/DE98/02876**

(22) Anmeldetag: **28.09.1998**

(87) Internationale Veröffentlichungsnummer:
**WO 99/18578 (15.04.1999 Gazette 1999/15)**

(54) **SPEICHERZELLENANORDNUNG**

MEMORY CELL ARRANGEMENT

AGENCEMENT DE CELLULES DE MEMOIRE

(84) Benannte Vertragsstaaten:
**DE FR GB IE IT**

(30) Priorität: **06.10.1997 DE 19744095**

(43) Veröffentlichungstag der Anmeldung:
**19.07.2000 Patentblatt 2000/29**

(73) Patentinhaber: **Infineon Technologies AG
81669 München (DE)**

(72) Erfinder:
• **SCHWARZL, Siegfried
D-85579 Neubiberg (DE)**
• **RISCH, Lothar
D-85579 Neubiberg (DE)**

(74) Vertreter: **Zimmermann & Partner
Postfach 33 09 20
80069 München (DE)**

(56) Entgegenhaltungen:
**EP-A- 0 780 912          DE-A- 19 726 852**

**Beschreibung**

Die Erfindung betrifft eine Speicherzellenanordnung mit Speicherelementen mit einer Schichtstruktur mit sehr großem magnetoresistivem Effekt.

Aus der Technologieanalyse XMR-Technologien , Technologiefrüherkennung, Verfasser Stefan Mengel, Herausgeber VDI-Technologiezentrum Physikalische Technologien, sind Schichtstrukturen mit magnetoresisitvem Effekt bekannt. Je nach Aufbau der Schichtstruktur wird unterschieden zwischen GMR-Element, TMR-Element AMR-Element und CMR-Element.

Der Begriff GMR-Element wird in der Fachwelt für Schichtstrukturen verwendet, die mindestens zwei ferromagnetische Schichten und eine dazwischen angeordnete nichtmagnetische, leitende Schicht aufweisen und den sogenannten GMR-(giant magnetoresistance) Effekt, das heißt einen im Vergleich zum AMR-(antisotropic magnetoresistance) Effekt großen magnetoresistiven Effekt zeigen. Unter dem GMR-Effekt wird die Tatsache verstanden, daß der elektrische Widerstand des GMR-Elements abhängig davon ist, ob die Magnetisierungen in den beiden ferromagnetischen Schichten parallel oder antiparallel ausgerichtet sind.

Der Begriff TMR-Element wird in der Fachwelt für "Tunneling Magnetoresistance"-Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nicht magnetische Schicht bewirkt wird. Auch in diesem Fall ist der elektrische Widerstand des TMR-Elementes abhängig davon, ob die Magnetisierungen in den beiden ferromagnetischen Schichten parallel oder antiparallel ausgerichtet sind.

Der AMR-Effekt äußert sich dadurch, daß der Widerstand in magnetisierten Leitern parallel und senkrecht zur Magnetisierungsrichtung verschieden ist. Er ist ein Volumeneffekt und tritt somit in ferromagnetischen Einfachschichten auf.

Ein weiterer Magnetowiderstandseffekt, der wegen seiner Größe ($\Delta R/R = 100$ Prozent ... 400 Prozent bei Raumtemperatur) Colossal Magnetoresistance Effekt genannt wird, erfordert wegen seiner hohen Koerzitivkräfte ein hohes Magnetfeld zum Umschalten zwischen den Magnetisierungszuständen.

Es ist vorgeschlagen worden (siehe zum Beispiel D. D. Tang et al, IEDM 95, Seiten 997 bis 999, D. D. Tang et al, IEEE Trans. on Magnetics, Vol. 31, Nr. 6, 1995, Seiten 3206 bis 3208, F. W. Patten et al, Int. Non Volatile Memory Technology Conf., 1996, Seiten 1 bis 2), GMR-Elemente als Speicherelemente in einer Speicherzellenanordnung zu verwenden. Dazu werden als Speicherelemente GMR-Elemente verwendet, bei denen die Magnetisierungsrichtung der einen ferromagnetischen Schicht zum Beispiel durch eine benachbarte antiferromagnetische Schicht festgehalten wird. Die Speicherelemente werden über Leseleitungen in Reihe verschaltet. Quer dazu verlaufen Wortleitungen, die sowohl gegenüber den Leseleitungen als auch gegenüber den Speicherelementen isoliert sind. An die Wortleitungen angelegte Signale verursachen durch den in der Wortleitung fließenden Strom ein Magnetfeld, das bei hinreichender Stärke die darunter befindlichen Speicherelemente beeinflußt. Zum Einschreiben von Information werden eine Bitleitung und eine Wortleitung, die als X/Y-Leitungen bezeichnet werden und die sich oberhalb der zu beschreibenden Speicherzelle kreuzen, mit Signalen beaufschlagt, die am Kreuzungspunkt ein für die Ummagnetisierung ausreichendes magnetisches Feld verursachen. Zum Auslesen der Information wird die Wortleitung mit einem Signal beaufschlagt, durch das die betreffende Speicherzelle zwischen den beiden Magnetisierungszuständen hin und her geschaltet wird. Gemessen wird der Strom durch die Leseleitung, aus dem der Widerstandswert des entsprechenden Speicherelementes ermittelt wird.

In S. Tehrani et al, IEDM 96, Seite 193 ff., ist vorgeschlagen worden, als Speicherelement ein GMR-Element zu verwenden, das unterschiedlich dicke ferromagnetische Schichten aufweist. Das Magnetfeld zum Einschreiben von Information wird so bemessen, daß es nur die Magnetisierung in der dünneren der beiden ferromagnetischen Schichten beeinflußt. Die Magnetisierung in der dickeren der beiden ferromagnetischen Schichten bleibt davon unbeeinflußt.

Der Erfindung liegt das Problem zugrunde, eine Speicherzellenanordnung mit Speicherelementen mit magnetoresistiven Effekt anzugeben, die mit erhöhter Packungsdichte herstellbar ist.

Dieses Problem wird durch eine Speicherzellenanordnung gemäß Anspruch 1 gelöst. Weitere Ausgestaltungen der Erfindung gehen aus den übrigen Ansprüchen hervor.

Die Speicherzellenanordnung weist untereinander im wesentlichen parallel verlaufende Wortleitungen und untereinander im wesentlichen parallel verlaufende Bitleitungen auf, wobei die Wortleitungen quer zu den Bitleitungen verlaufen. Es sind Speicherelemente mit einer Schichtstruktur mit magnetoresistiven Effekt vorgesehen, die jeweils zwischen einer der Wortleitungen und einer der Bitleitungen angeordnet sind.

Für die Wort- und Bitleitungen wird im Zusammenhang mit magnetischen Speichern in der Literatur auch häufig der Begriff X- oder Y-Leitung verwendet.

Die Speicherelemente sind in mindestens zwei Lagen angeordnet. Diese Lagen sind übereinander gestapelt. Dadurch sinkt der Flächenbedarf pro Speicherelement und die Packungsdichte wird erhöht. Je größer die Anzahl der Lagen, die übereinander gestapelt sind, desto höher ist die erzielbare Packungsdichte. Jede Lage Speicherelemente ist dabei zwischen zwei Leitungsebenen angeordnet, wobei die eine Leitungsebene Bitleitungen und die andere Leitungsebene Wortleitungen enthält. Die Bitleitungen und die Wortleitungen kreuzen sich. Zwischen benachbarten Lagen ist jeweils eine Leitungsebene, die Bitleitungen oder Wortleitungen enthält, vorgesehen.

Die sich kreuzenden Wortleitungen und Bitleitungen sind jeweils mit minimalen Abmessungen und Abständen von einer minimalen Strukturgröße F herstellbar, so daß sich pro Lage ein Flächenbedarf pro Speicherelement von $4F^2$ ergibt. Insgesamt ergibt sich in der Speicherzellenanordnung bei n Lagen ein Flächenbedarf von $4F^2/n$ pro Speicherelement.

Vorzugsweise ist die Speicherzellenanordnung in Dünnschichttechnik auf einem Halbleitersubstrat realisiert. In dem Halbleitersubstrat sind Bauelemente zur Ansteuerung der Speicherzellenanordnung enthalten.

Als Speicherelement sind alle bekannten TMR-Elemente und GMR-Elemente in CPP-Anordnung (current perpendicular to plane) geeignet. Der GMR-Effekt ist größer, wenn der Strom senkrecht durch den Schichtstapel fließt (CPP), als wenn der Strom parallel in den Schichten (CIP current in plane) fließt. Darüberhinaus sind alle XMR-Elemente geeignet, die zwei Magnetisierungszustände mit unterschiedlichem Widerstand aufweisen, zwischen denen durch Anlegen eines Magnetfeldes, dessen Höhe für die Speicheranwendung verträglich ist, hin und her geschaltet werden kann.

Vorzugsweise weisen die Speicherelemente jeweils zwei ferromagnetische Schichten und eine dazwischen angeordnete nichtmagnetische, isolierende (TMR) bzw. leitende (GMR) Schicht auf. Die Speicherelemente weisen jeweils zwei Magnetisierungszustände auf. Es ist vorteilhaft, eine isolierende, nichtmagnetische Schicht zu verwenden (TMR-Element), weil dadurch höhere Elementwiderstände ($\geq 100$ k$\Omega$) erzielbar sind, die hinsichtlich Leistungsverbrauch und Signal/Rausch-Verhältnis günstiger sind.

Eine der ferromagnetischen Schichten ist vorzugsweise einer antiferromagnetischen Schicht benachbart angeordnet, die die Magnetisierungsrichtung in der benachbarten ferromagnetischen Schicht fixiert. Für die antiferromagnetische Schicht sind unter anderem Materialien geeignet, die mindestens eines der Elemente Fe, Mn, Ni, Ir, Tb und O enthalten.

Alternativ können die Speicherelemente jeweils zwei ferromagnetische Schichten und eine dazwischen angeordnete nicht magnetische Schicht aufweisen, wobei eine der ferromagnetischen Schichten dicker als die andere ferromagnetische Schicht ist oder die ferromagnetischen Schichten aus verschiedenen Materialien mit unterschiedlichen magnetischen Eigenschaften gebildet sind, oder eine nicht magnetische nicht isolierende Schicht aufweisen. Dadurch wird erreicht, daß nur eine ferromagnetische Schicht ummagnetisiert wird, während die andere unbeeinflußt bleibt.

Für die ferromagnetischen Schichten sind unter anderem Materialien geeignet, die mindestens eines der Elemente Fe, Ni, Co, Cr, Mn, Gd, Dy enthalten. Die Dicke der ferromagnetischen Schichten beträgt maximal 20 nm und liegt vorzugsweise im Bereich zwischen 2 und 10 nm. Für die nicht magnetische Schicht, die als Tunnelisolator wirkt, ist als isolierendes Material $Al_2O_3$, $NiO$, $HfO_2$, $TiO_2$, $NbO$ oder $SiO_2$ geeignet. Als nicht isolierendes Material für die nicht magnetische Schicht ist Cu oder Ag geeignet. Die Dicke der nicht magnetischen Schicht liegt im Bereich zwischen 1 und 4 nm, vorzugsweise zwischen 2 und 3 nm.

Die Speicherelemente weisen vorzugsweise Abmessungen im Bereich zwischen 0,05 $\mu$m und 20 $\mu$m auf. Sie können unter anderem quadratisch oder langgestreckt ausgestaltet sein.

Zum Einschreiben von Information in eines der Speicherelemente werden die zugehörige Wortleitung und die zugehörige Bitleitung jeweils mit einem Signal beaufschlagt. Dadurch fließt ein Strom über die Wortleitung und die Bitleitung, der jeweils ein Magnetfeld induziert. Am Kreuzungspunkt der Wortleitung und der Bitleitung ist das Gesamtmagnetfeld, das sich durch Überlagerung der beiden Magnetfelder ergibt, so groß, daß es zu einer Ummagnetisierung des dort befindlichen Speicherelementes kommt. Außerhalb des Kreuzungspunktes sind die einzelnen Magnetfelder für eine Ummagnetisierung der dort befindlichen Speicherelemente zu gering.

Das Auslesen der Information kann auf verschiedene Weise erfolgen. Zum Auslesen der Information kann die Wortleitung mit einem Signal beaufschlagt werden, durch das das betreffende Speicherelement von einem ersten Magnetisierungszustand in einen zweiten Magnetisierungszustand schaltbar ist. Es wird der Strom gemessen durch die Bitleitung, die mit dem Speicherelement verbunden ist. Wird der Magnetisierungszustand bei diesem Vorgang umgeschaltet, so ändert sich der Strom. Aus dem Auftreten bzw. Nichtauftreten einer Stromänderung wird auf die gespeicherte Information geschlossen. Wird der Magnetisierungszustand bei dem Auslesevorgang verändert, so muß die ursprüngliche Information anschließend zurückgeschrieben werden.

Vorzugsweise sind die Bitleitungen jeweils mit einem Leseverstärker verbunden, über den das Potential an der jeweiligen Bitleitung auf ein Referenzpotential regelbar ist und an dem ein Ausgangssignal abgreifbar ist. Die Speicherelemente sind jeweils zwischen die zugehörige Wortleitung und Bitleitung geschaltet. Zum Auslesen dieser Speicherzellenanordnung werden alle nicht ausgewählten Wortleitungen auf das Referenzpotential gelegt. An die ausgewählte Wortleitung wird ein Signal mit anderem Potential angelegt. Dadurch wird ein Strompfad von der ausgewählten Wortleitung zu allen Bitleitungen geschlossen. Aus dem Ausgangssignal am jeweiligen Leseverstärker, den elektrischen Kenngrößen des Leseverstärkers wie zum Beispiel dem Rückkoppelwiderstand, und dem Referenzpotential und dem Bitleitungswiderstand läßt sich der Widerstand des am Kreuzungspunkt der Wortleitung mit der jeweiligen Bitleitung befindlichen Speicherelementes bestimmen. Beim Auslesen dieser Speicherzellenanordnung tritt daher keine Veränderung der gespeicherten Information auf.

Vorzugsweise weist der Leseverstärker einen rückgekoppelten Operationsverstärker auf. Der nicht invertierende Eingang des Operationsverstärkers wird mit Referenzpotential, zum Beispiel mit Erde, verbunden. Die Bitleitung wird mit dem invertierenden Eingang verbunden. Beträgt das Referenzpotential 0 Volt, so stellt dieser Operationsverstärker sicher, daß an der Bitleitung 0 Volt anliegen. Das Ausgangssignal des Operationsverstärkers ist ein Maß für den Widerstand des ausgewählten Speicherelementes.

Im folgenden wird die Erfindung anhand eines Ausführungsbeispiels, das in den Figuren dargestellt ist, näher erläutert.

Figur 1    zeigt ein Speicherelement mit zugehöriger Bitleitung und Wortleitung.

Figur 2    zeigt einen Schnitt durch eine Speicherzellenanordnung, die mehrere Lagen mit Speicherelementen aufweist.

Figur 3    zeigt die Architektur der Speicherzellenanordnung.

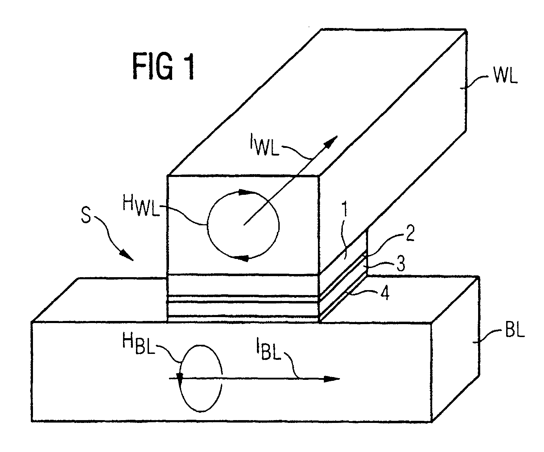

Ein Speicherelement S weist eine erste ferromagnetische Schicht 1, eine nicht magnetische Schicht 2, eine zweite ferromagnetische Schicht 3 und eine antiferromagnetische Schicht 4 auf (siehe Figur 1). Die erste ferromagnetische Schicht 1, die nicht magnetische Schicht 2 und die zweite ferromagnetische Schicht 3 stellen eine Schichtstruktur dar. Die erste ferromagnetische Schicht 1 und die zweite ferromagnetische Schicht 3 enthalten NiFe und weisen eine Dicke von 10 nm auf. Die nicht magnetische Schicht 2 enthält $Al_2O_3$ und weist eine Dicke von 2 bis 3 nm auf. Die antiferromagnetische Schicht 4 enthält FeMn und weist eine Dicke von 10 bis 20 nm auf. Die erste ferromagnetische Schicht 1 grenzt an eine Wortleitung WL an. Die antiferromagnetische Schicht 4 grenzt an die Bitleitung BL an. Die Bitleitung BL verläuft unterhalb der Wortleitung WL. Alternativ kann die Bitleitung BL auch oberhalb der Wortleitung WL verlaufen. In der durch die Bitleitungen BL und die Wortleitung WL aufgespannten Ebene weist das Speicherelement S einen Querschnitt von zum Beispiel 0,25 μm x 0,25 μm auf.

Die Bitleitungen BL und die Wortleitungen WL werden jeweils aus A1 mit 0,5 Gew % Cu in einer Dicke gebildet, die so dimensioniert ist, daß die Stromdichte in den Bitleitungen BL bzw. Wortleitungen WL $10^6$ A/cm$^2$ nicht überschreitet.

Zum Einschreiben von Information in das Speicherelement wird der Wortleitung WL ein Strom $I_{WL}$ und der Bitleitung BL ein Strom $I_{BL}$ eingeprägt. Diese Ströme induzieren um die Wortleitung WL ein Magnetfeld $H_{WL}$ und um die Bitleitung $B_L$ ein Magnetfeld $H_{BL}$. Am Kreuzungspunkt von Bitleitung und Wortleitung ist das resultierende Magnetfeld so groß, daß es die Magnetisierung der ersten ferromagnetischen Schicht 1 beeinflußt. Die Magnetisierung der zweiten ferromagnetischen Schicht 3 ist durch die antiferromagnetische Schicht 4, die dieser benachbart ist, festgelegt.

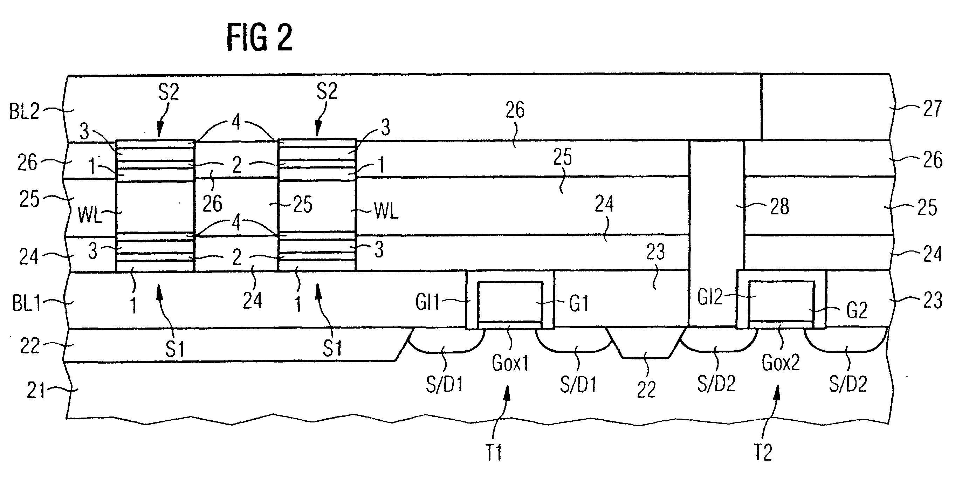

Ein Halbleitersubstrat 21, zum Beispiel eine monokristalline Siliziumscheibe oder eine monokristalline Siliziumschicht, die an der Oberfläche einer auf einem Trägerkörper angeordneten isolierenden Schicht eines SOI-Substrats angeordnet ist, weist im Bereich einer Oberfläche eine Isolationsstruktur 22 auf (siehe Figur 2). Die Isolationsstruktur 22 enthält $SiO_2$ und wird zum Beispiel durch lokale Oxidation in einem LOCOS-Prozeß oder durch Bildung flacher Gräben, die mit isolierendem Material aufgefüllt werden, in einem Shallow-Trench-Isolation (STI)-Prozeß gebildet.

Die Isolationsstruktur 22 bedeckt das Substrat 21 im Bereich eines Zellenfeldes und definiert aktive Gebiete im Bereich einer Peripherie.

Im Bereich des Zellenfeldes sind an der Oberfläche der Isolationsstruktur 22 streifenförmige, untereinander parallel verlaufende erste Bitleitungen BL1 angeordnet. Die Bitleitungen BL1 weisen eine Dicke von 0,6 μm, eine Länge von 50 μm, eine Breite von 0,25 μm und einen Abstand zwischen benachbarten ersten Bitleitungen BL1 von 0,25 μm auf. Die Bitleitungen BL1 werden zum Beispiel aus AlCu oder Siliziden gebildet. Benachbarte erste Bitleitungen BL1 sind durch eine planarisierende isolierende Schicht 23 aus $SiO_2$ oder $Si_3N_4$ gegeneinander isoliert.

Auf der Oberfläche der ersten Bitleitungen BL1 sind rasterförmig in einer ersten Lage Speicherelemente S1 angeordnet. Die Speicherelemente S1 sind so aufgebaut wie das Speicherelement S, das anhand von Figur 1 erläutert wurde. Sie weisen jeweils eine erste ferromagnetische Schicht 1, eine nicht magnetische Schicht 2, eine zweite ferromagnetische Schicht 3 und eine antiferromagnetische Schicht 4 auf. Die erste ferromagnetische Schicht 1 und die zweite ferromagnetische Schicht 3 enthalten NiFe und weisen eine Dicke von 10 nm auf. Die nicht magnetische Schicht 2 enthält $Al_2O_3$ und weist eine Dikke von 2 bis 3 nm auf. Die antiferromagnetische Schicht 4 enthält FeMn und weist eine Dicke von 10 bis 20 nm auf. Parallel zur Oberfläche des Substrats 21 weisen die Speicherelemente S1 jeweils einen Querschnitt von 0,25 μm x 0,25 μm auf.

Die Speicherelemente S1 sind gegeneinander durch eine planarisierende isolierende Schicht 24 aus $SiO_2$ oder $Si_3N_4$ isoliert.

Oberhalb der ersten Lage Speicherelemente S1 sind streifenförmige, untereinander parallel verlaufende Wortleitungen angeordnet, die senkrecht zu den ersten Bitleitungen BL1 verlaufen. Die Speicherelemente S1 der ersten Lage sind jeweils am Kreuzungspunkt zwischen einer der Wortleitungen WL und einer der ersten Bitleitungen BL1 angeordnet. Die Wortleitungen WL weisen eine Dicke von zum Beispiel 0,6 µm auf. Sie enthalten AlCu und Ti/TiN. Die Breite der Wortleitungen WL beträgt 0,25 µm, der Abstand zwischen benachbarten Wortleitungen WL beträgt 0,25 µm. Die Länge der Wortleitungen WL beträgt 5000 µm. Zwischen benachbarten Wortleitungen WL ist eine planarisierende Isolationsschicht 25 aus $SiO_2$ angeordnet.

Oberhalb der Wortleitungen WL ist eine zweite Lage Speicherelemente S2 angeordnet. Die Speicherelemente S2 sind wie die Speicherelemente S1 der ersten Lage rasterförmig angeordnet. Sie sind jeweils mit einer der Wortleitungen WL in Kontakt. Die Speicherelemente S2 sind wie die Speicherelemente S1 aufgebaut und weisen eine erste ferromagnetische Schicht 1, eine nicht magnetische Schicht 2, eine zweite ferromagnetische Schicht 3 und eine antiferromagnetische Schicht 4 auf. Für die Dicken und die Materialien der Speicherelemente S2 gilt das in Zusammenhang mit den Speicherelementen S1 Gesagte.

Benachbarte Speicherelemente S2 der zweiten Lage sind durch eine planarisierende isolierende Schicht 26 gegeneinander isoliert. Sie wird zum Beispiel durch Abscheiden und chemisch mechanisches Polieren aus $SiO_2$ oder $Si_3N_4$ gebildet.

Oberhalb der zweiten Lage Speicherelemente S2 sind zweite Bitleitungen BL2 angeordnet. Sie sind streifenförmig und verlaufen untereinander parallel. Darüber hinaus verlaufen sie parallel zu den ersten Bitleitungen BL1. Die zweiten Bitleitungen BL2 enthalten AlCu und Ti/TiN und weisen eine Dicke von 0,6 µm und eine Länge von 50 µm auf. Sie weisen eine Breite von 0,25 µm und einen Abstand zwischen benachbarten zweiten Bitleitungen BL2 von 0,25 µm auf. Benachbarte zweite Bitleitungen BL2 sind durch eine planarisierende isolierende Schicht 27, zum Beispiel aus $SiO_2$, gegeneinander isoliert.

In der Peripherie sind in dem Substrat 21 erste Transistoren T1 und zweite Transistoren T2 angeordnet, über die jeweils eine der ersten Bitleitungen BL1 bzw. eine der zweiten Bitleitungen BL2 ansteuerbar ist. Der erste Transistor T1 weist Source-/Drain-Gebiete S/D1, ein Gateoxid GOX1, eine Gateelektrode G1 und eine Gateisolation GI1 auf. Der zweite Transistor T2 weist Source-/Drain-Gebiete S/D2, ein Gateoxid GOX2, eine Gateelektrode G2 und eine Gateisolation GI2 auf.

Die ersten Bitleitungen BL1 stehen jeweils mit einem der Source-/Drain-Gebiete S/D1 des jeweiligen ersten Transistors T1 in Verbindung. Dieses erfolgt zum Beispiel dadurch, daß die erste Bitleitung BL1 bis auf die Oberfläche des betreffenden Source-/Drain-Gebietes S/D1 reicht. Die zweite Bitleitung BL2 ist mit dem zugehörigen zweiten Transistor T2 über einen Kontakt 28 verbunden. Der Kontakt 28 wird zum Beispiel durch Öffnen eines tiefreichendes Kontaktloches, das die planarisierenden, isolierenden Schichten 23, 24, 25, 26 durchquert und das mit einer metallischen Füllung aufgefüllt wird, realisiert. Das Kontaktloch kann alternativ in einem mehrstufigen Prozeß insbesondere gleichzeitig mit der Strukturierung der ersten Bitleitungen BL1, der ersten Lage Speicherelemente S1, der Wortleitungen WL, zweiten Lage Speicherelemente S2 und der zweiten Bitleitungen BL2 geöffnet und gefüllt werden. Der Kontakt 28 reicht auf die Oberfläche eines der Source-/Drain-Gebiete S/D2 des zweiten Transistors T2.

Der Flächenbedarf pro Speicherzelle beträgt in diesem Beispiel 4 $(0,25 \, \mu m)^2/2$.

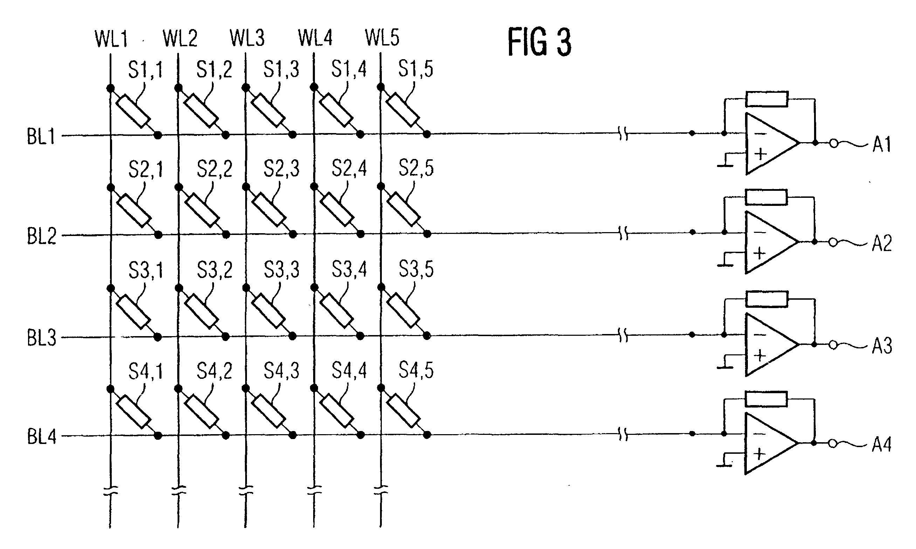

Die Speicherzellenanordnung weist untereinander im wesentlichen parallel verlaufende Bitleitungen BLi, i = 1, 2, ... n auf. Quer dazu verlaufen Wortleitungen WLj, j = 1, 2, ... m. Die Wortleitungen WLj verlaufen ebenfalls untereinander im wesentlichen parallel. An den Kreuzungspunkten der Bitleitungen BLi mit den Wortleitungen WLj ist in jeder Lage jeweils ein Speicherelement Si,j angeordnet (siehe Figur 3).

Die Bitleitungen BLi sind jeweils mit dem invertierenden Eingang eines Operationsverstärkers OPi, i = 1, 2 ... n verbunden. Der nicht invertierende Eingang des Operationsverstärkers OPi ist mit Erdpotential verbunden. Die Operationsverstärker OPi sind rückgekoppelt und weisen jeweils einen Rückkopplungswiderstand RKi auf. Die Operationsverstärker OPi weisen jeweils einen Ausgang Ai auf.

In dieser Speicherzellenanordnung wird den logischen Größen Null und Eins jeweils einer der Widerstandswerte der Speicherelemente Si,j zugeordnet.

Zum Auslesen der in der Speicherzellenanordnung gespeicherten Information wird zum Auslesen der in dem Speicherelement Si,j gespeicherten Information die Wortleitung WLj angesteuert. Dazu wird die Wortleitung WLj auf ein Potential von zum Beispiel + 1 Volt gelegt. Alle andere Wortleitungen WLl, l ≠ j werden auf 0 Volt gelegt. Alle Bitleitungen BLi, i = 1 ... n liegen ebenfalls auf 0 Volt, da sie mit dem invertierenden Eingang des rückgekoppelten Operationsverstärkers OPi verbunden sind, der sich stets auf 0 Volt regelt. Am Ausgang Ai des Operationsverstärkers OPi wird eine Spannung

$$U_{out} = 1 \, V * \frac{R}{(Rx + Rl)}$$

abgegriffen, wobei R der Widerstand des Rückkoppelwiderstandes RKi, Rx der Widerstand des Speicherelementes Si,j und Rl der Widerstand der Leitungsanteile der Wortleitung WLj und der Bitleitung Bli, über die der Strom fließt, ist. Aus dieser Spannung läßt sich der Widerstand Rx des Speicherelementes Si,j berechnen, da die übrigen Größen bekannt sind.

Die Bitleitungen BLi und die Wortleitungen WLj werden aus Metall gebildet, so daß ihr Widerstand sehr klein ist. Der Rückkoppelwiderstand RKi beträgt zum Beispiel 100 kΩ. Der Widerstand Rx des Speicherelementes Si,j beträgt etwa 100 kΩ, falls die Magnetisierung von der ersten ferromagnetischen Schicht 1 und der zweiten ferromagnetischen Schicht 3 parallel ausgerichtet ist und 110 kΩ, falls die Magnetisierung von der ersten ferromagnetischen Schicht 1 und der zweiten ferromagnetischen Schicht 3 antiparallel ausgerichtet ist. Es sind je Lage 100 Bitleitungen BLi und 10000 Wortleitungen WLj vorgesehen. Damit beträgt die Änderung des Eingangssignals abhängig von dem angenommenen Widerstandswert des Speicherelementes Si,j 100 mV. Mit einem Widerstandsverhältnis $\frac{R}{(Rx + Rl)}$ von 10 kann sie am Ausgang Ai des Operationsverstärkers OPi auf 1 Volt verstärkt werden.

Da alle Bitleitungen BLi auf 0 Volt liegen, fließen zwischen den Bitleitungen BLi keine parasitären Ströme. Der Strompfad ist nur zwischen der ausgewählten Wortleitung WLj und allen Bitleitungen geschlossen. Es ist daher vorteilhaft, eine größere Anzahl an Wortleitungen WLj als Bitleitungen BLi zu verwenden. Eine Speicherzellenanordnung mit 1 Mbit pro Lage Speicherelemente wird vorzugsweise mit n = 100 Bitleitungen BLi und M = 10.000 Wortleitungen WLj aufgebaut. Damit sind nur 100 Leseverstärker je Lage erforderlich. Der Strom, der jeweils in die ausgewählten Wortleitungen BLj fließt, ergibt sich aus der Parallelschaltung von 100 Speicherelementen Si,j, die jeweils einen Widerstand von etwa 100 kΩ aufweisen. Diese Parallelschaltung weist einen Widerstand von etwa 1 kΩ auf. Die Länge der Bitleitungen BLi spielt dabei keine Rolle, da diese nicht umgeladen wird.

Zum Einschreiben von Informationen in die Speicherzelle Si,j wird der Bitleitung BLi und der Wortleitung WLj jeweils ein Strom $I_{WL}$, $I_{BL}$ in der Größenordnung mA eingeprägt. Dieser Strom induziert um die Schreibleitung BLi und die Wortleitung WLj jeweils ein Magnetfeld $H_{WL}$, $H_{BL}$, das am Kreuzungspunkt der Bitleitung BLi und der Wortleitung WLj die Magnetisierung der ersten ferromagnetischen Schicht 1 beeinflußt (siehe Figur 1). Die Magnetisierung der zweiten ferromagnetischen Schicht 3 ist durch die antiferromagnetische Schicht 4, die dieser benachbart ist, festgelegt.

**Patentansprüche**

1. Speicherzellenanordnung,

   - bei der mehrere untereinander im wesentlichen parallel verlaufende Wortleitungen (WLj) und mehrere untereinander im wesentlichen parallel verlaufende Bitleitungen (BLi) vorgesehen sind, wobei die Wortleitungen (WLj) quer zu den Bitleitungen (BLi) verlaufen, und

   - bei der Speicherelemente (Si,j) mit einer Schichtstruktur mit magnetoresistivem Effekt vorgesehen sind, die jeweils zwischen einer der Wortleitungen (WLj) und einer der Bitleitungen (BLi) angeordnet sind,

   - **dadurch gekennzeichnet, daß** die Speicherelemente (Si,j) in mindestens zwei Lagen angeordnet sind, die übereinander angeordnet sind.

2. Speicherzellenanordnung nach Anspruch 1,

   - bei der die Speicherelemente (Si,j) jeweils zwei ferromagnetische Schichten (1,3) und eine dazwischen angeordnete nicht magnetische Schicht (2) aufweisen,

   - bei der die Speicherelemente (Si,j) jeweils zwei Magnetisierungszustände aufweisen.

3. Speicherzellenanordnung nach Anspruch 2,

   - bei der die ferromagnetischen Schichten (1,3) jeweils mindestens eines der Elemente Fe, Ni, Co, Cr, Mn, Gd, Dy enthalten,

   - bei der die Dicke der ferromagnetischen Schichten (1,3) jeweils kleiner oder gleich 20 nm ist,

   - bei der die nicht magnetische Schicht (2) mindestens eines der Materialien $Al_2O_3$, NiO, $HfO_2$, $TiO_2$, NbO, $SiO_2$ enthält und eine Dicke im Bereich zwischen 1 and 4 nm aufweist.

4. Speicherzellenanordnung nach 2 oder 3,

   - bei der eine antiferromagnetische Schicht (4) vorgesehen ist, die einer der ferromagnetischen Schichten (1,3) benachbart ist und die die Magnetisierungsrichtung in der benachbarten ferromagnetischen Schicht (1,3) bestimmt.

5. Speicherzellenanordnung nach Anspruch 4, bei der antiferromagnetische Schicht (4) mindestens eines der Elemente Fe, Mn, Ni, Ir, Tb und O enthält.

6. Speicherzellenanordnung nach einem der Ansprüche 1 bis 5, bei der die Speicherelemente (Si,j) in einer Ebene, die von den Wortleitungen (WLj) und den Bitleitungen (BLi) aufgespannt wird, Abmessungen im Bereich zwischen 0,5 μm und 20 μm aufweisen.

7. Speicherzellenanordnung nach einem der Ansprüche 1 bis 6,

   - bei der die Speicherelemente (Si,j) hochohmiger als die Bitleitungen (BLi) und die Wortleitungen (WLj) sind und jeweils zwischen eine der Wortleitungen (WLj) und eine der Bitleitungen (BLi) geschaltet sind,

- bei dem die Bitleitungen (BLi) jeweils mit einem Leseverstärker verbunden sind, über den das Potential an der jeweiligen Bitleitung (BLi) auf ein Referenzpotential regelbar ist und an dem ein Ausgangssignal abgreifbar ist.

**8.** Speicherzellenanordnung nach Anspruch 7, bei der der Leseverstärker einen rückgekoppelten Operationsverstärker aufweist.

**9.** Speicherzellenanordnung nach Anspruch 7 oder 8, bei der je Lage der Speicherelemente (Si,j) die Zahl der Wortleitungen (WLj) größer als die Zahl der Bitleitungen (BLi) ist.

**Claims**

**1.** Memory cell arrangement,

- in which a plurality of word lines (WLj) running essentially parallel to one another and a plurality of bit lines (Bli) running essentially parallel to one another are provided, the word lines (WLj) running transversely with respect to the bit lines (Bli), and
- in which memory elements (Si,j) having a layer structure with a magnetoresistive effect are provided, which memory elements are respectively arranged between one of the word lines (WLj) and one of the bit lines (Bli),
- **characterized in that** the memory elements (Si,j) are arranged in at least two layers which are arranged one above the other.

**2.** Memory cell arrangement according to Claim 1,

- in which the memory elements (Si,j) each have two ferromagnetic layers (1,3) and a non-magnetic layer (2) arranged in between,
- in which the memory elements (Si,j) each have two magnetization states.

**3.** Memory cell arrangement according to Claim 2,

- in which the ferromagnetic layers (1,3) each contain at least one of the elements Fe, Ni, Co, Cr, Mn, Gd, Dy,
- in which the thickness of the ferromagnetic layers (1,3) is in each case less than or equal to 20 nm,
- in which the non-magnetic layer (2) contains at least one of the materials $Al_2O_3$, NiO, $HfO_2$, $TiO_2$, NbO, $SiO_2$ and has a thickness in the range between 1 and 4 nm.

**4.** Memory cell arrangement according to Claim 2 or 3,

- in which an antiferromagnetic layer (4) is provided, which is adjacent to one of the ferromagnetic layers (1,3) and determines the magnetization direction in the adjacent ferromagnetic layer (1,3).

**5.** Memory cell arrangement according to Claim 4, in which the antiferromagnetic layer (4) contains at least one of the elements Fe, Mn, Ni, Ir, Tb and O.

**6.** Memory cell arrangement as claimed in one of claims 1 to 5, in which the memory elements (Si,j), in a plane spanned by the word lines (WLj) and the bit lines (BLi), have dimensions in the range between $0.5\,\mu m$ and $20\,\mu m$.

**7.** Memory cell arrangement as claimed in one of claims 1 to 6,

- in which the memory elements (Si,j) have a higher resistance than the bit lines (Bli) and the word lines (WLj) and are respectively connected between one of the word lines (WLj) and one of the bit lines (Bli),
- in which the bit lines (Bli) are each connected to a sense amplifier by means of which the potential on the respective bit line (Bli) can be regulated to a reference potential and at which an output signal can be picked off.

**8.** Memory cell arrangement according to Claim 7, in which the sense amplifier has a feedback operational amplifier.

**9.** Memory cell arrangement according to Claim 7 or 8, in which, depending on the layer of memory elements (Si,j), the number of word lines (WLj)is greater than the number of bit lines (BLi).

**Revendications**

**1.** Agencement de cellules de mémoire,

- dans lequel il est prévu plusieurs lignes (WLj) de mots s'étendant sensiblement parallèlement entre elles et plusieurs lignes (BLi) de bits s'étendant sensiblement parallèlement entre elles, les lignes (WLj) de mots s'étendant transversalement aux lignes (BLi) de bits et
- dans lequel il est prévu des éléments (Si, j) de mémoire ayant une structure stratifiée à effet magnétorésistif, qui sont disposés respectivement entre l'une des lignes (WLj) de mots et l'une des lignes (BLi) de bits,

- **caractérisé en ce que** les éléments (Si, j) de mémoire sont disposés en au moins deux strates qui sont superposées.

2. Agencement de cellules de mémoire suivant la revendication 1,

- dans lequel les éléments (Si, j) de mémoire ont respectivement deux couches (1, 3) ferromagnétiques et une couche (2) non magnétique interposée entre elles,
- dans lequel les éléments (Si, j) de mémoire ont respectivement deux états de magnétisation.

3. Agencement de cellules de mémoire suivant la revendication 2,

- dans lequel les couches (1, 3) ferromagnétiques renferment respectivement au moins l'un des éléments Fe, Ni, Co, Cr, Mn, Gd, Dy,
- dans lequel l'épaisseur des couches (1, 3) ferromagnétiques est respectivement inférieure ou égale à 20 nm,
- dans lequel la couche (2) non magnétique renferme au moins l'une des substances $Al_2O_3$, NiO, $HfO_2$, $TiO_2$, NbO, $SiO_2$ et a une épaisseur de l'ordre de 1 à 4 nm.

4. Agencement de cellules de mémoire suivant la revendication 2 ou 3,

- dans lequel il est prévu une couche (4) antiferromagnétique, qui est voisine de l'une des couches (1, 3) ferromagnétiques et qui détermine la direction de magnétisation dans la couche (1, 3) ferromagnétique voisine.

5. Agencement de cellules de mémoire suivant la revendication 4,
  dans lequel la couche (4) antiferromagnétique renferme au moins l'un des éléments Fe, Mn, Ni, Ir, Tb et O.

6. Agencement de cellules de mémoire suivant l'une des revendications 1 à 5,
  dans lequel les éléments (Si, j) de mémoire ont, dans un plan défini par les lignes (WLj) de mots et les lignes (BLi) de bits, des dimensions de l'ordre de 0,5 μm à 20 μm.

7. Agencement de cellules de mémoire suivant l'une des revendications 1 à 6,

- dans lequel les éléments (Si, j) de mémoire sont à plus grande valeur ohmique que les lignes (BLi) de bits et que les lignes (WLj) de mots et sont montés respectivement l'une des lignes (WLj) de mots et l'une des lignes (BLi) de bits,

- dans lequel les lignes (BLi) de bits sont reliées respectivement à un amplificateur de lecture, par lequel le potentiel appliqué à la ligne (BLi) de bits respective peut être réglé à un potentiel de référence et duquel on peut prélever un signal de sortie.

8. Agencement de cellules de mémoire suivant la revendication 7,
  dans lequel l'amplificateur de lecture comporte un amplificateur opérationnel de réaction.

9. Agencement de cellules de mémoire suivant la revendication 7 ou 8,
  dans lequel pour chaque strate des éléments (Si, j) de mémoire, le nombre des lignes (WLj) de mots est plus grand que le nombre des lignes (BLi) de bits.

FIG 1

# FIG 2

EP 1 019 913 B1

FIG 3

EP 1 019 913 B1